# EUROPEAN PATENT APPLICATION

(11) **EP 4 422 030 A1**
(43) Date of publication of application: **28.08.2024**
(21) Application number: 23157712.3
(22) Date of filing: 21.02.2023
(51) Int. Cl.: H02J 50/00, B65D 63/10, G01R 19/00, H01F 27/25

(54) **ELECTRONIC DEVICE FOR LOW-VOLTAGE ELECTRICAL INSTALLATIONS**

(71) Applicant: ABB S.p.A., 20124 Milano (IT)
(72) Inventor: Tomasini, Marco, 24010 Sorisole (BG) (IT); Gallo, Paolo, 96010 Palazzolo Acreide (SR) (IT); Casalinuovo, Francesco, 24123 Bergamo (BG) (IT); Jamshidi Alamdari, Shaghayegh, 20137 Milano (MI) (IT)
(74) Representative: De Bortoli, Eros

(57) **Abstract**

An electronic device for low-voltage electrical installations comprising:
- a first operational unit having a first insulating housing;
- a data processing arrangement accommodated in the internal volume of said first operational unit and configured to receive and process detection signals indicative of one or more physical quantities and provided by one or more sensors;
- a flexible belt of magnetic material having an intermediate portion and opposite first and second end portions. Said intermediate portion passes through the internal volume of said operational unit and is mechanically coupled to said first insulating housing. Said first and second end portions are configured to wrap around a current carrying conductor to form a loop around said current carrying conductor;
- a power supply arrangement configured to feed said data processing arrangement by harvesting electric energy from a magnetic field generated by a current flowing along said current carrying conductor. The power supply arrangement includes a magnetic core formed by said belt of magnetic material and a secondary winding conductor accommodated in the internal volume of said first operational unit. The secondary winding conductor is wound around the intermediate portion of said belt of magnetic material and electrically connected to said data processing arrangement;
- a second operational unit configured to couple mechanically, in removable manner, the first and second end portions of said belt of magnetic material one to another to secure said electronic device to said current carrying conductor.

## Description

The present invention relates to the field of electrical installations, preferably operating at low-voltage levels. More particularly, the present invention relates to an electronic device, which is adapted to interface with one or more sensors detecting one or more physical quantities of an electrical installation and which is adapted to be secured to a current carrying conductor for being passively powered.

As widely known, in modern electric grids, an on-the-field monitoring of a number of physical quantities is mandatory for an efficient and safe management of electric power distribution in electrical installations and an effective scheduling of maintenance interventions.

In order to carry out the above-mentioned monitoring activity, it is common practice to install electronic devices capable of interfacing with one or more sensors to receive suitable detection signals from these latter. These electronic devices can normally process detection signals provided by the above-mentioned sensors and transmit remotely (in a wireless manner) the detection data so collected. Additionally, very often, they are directly arranged on live conductors of electrical installations in order to be passively powered, thereby avoiding the use of batteries for operating.

In actual electrical systems, however, the mounting or the removal of the above-mentioned electronic devices may be difficult and time consuming due to the limited available spaces and the need of using protection gloves and mechanical tools.

A further inconvenient derives from the circumstance that, in operation, these electronic devices are often subject to relevant spikes or peaks of the power supply voltage depending on possible current variations along the current carrying conductors on which they are installed. A careful design of the on-board electronics is therefore required to ensure a reliable operation of these electronic devices. Obviously, this implies an increase of the overall industrial costs of these electronic devices.

The main aim of the present invention is to provide an electronic device for low-voltage electrical installations, which allows the above-mentioned drawbacks to be overcome or mitigated.

Within this aim, a purpose of the present invention is to provide an electronic device that that can be interfaced with one or more sensors of an electrical installation and that is passively powered in such a way to be capable of operating without batteries onboard.

Another purpose of the present invention is to provide an electronic device, which can be easily installed on the field without the need of mechanical tools.

Another purpose of the present invention is to provide an electronic device, which has a relatively simple and compact structure and can be easily installed even if relatively small spaces are available.

Another purpose of the present invention is to provide an electronic device, which can be manufactured industrially at competitive costs compared to similar electronic devices currently available in the state of the art.

In order to fulfill these aim and objects, the present invention provides an electronic device, according to the following claim 1 and the related dependent claims.

In a general definition, the electronic device of the invention comprises:
- a first operational unit having a first insulating housing defining an internal volume of said first operational unit;
- a data processing arrangement accommodated in the internal volume of said first operational unit and configured to receive and process detection signals indicative of one or more physical quantities of an electrical installation and provided by one or more sensors operatively coupled to or included in said electronic device;
- a flexible belt of magnetic material having an intermediate portion and opposite first and second end portions. The intermediate portion passes through the internal volume of said first operational unit and it is mechanically coupled to said first insulating housing. The first and second end portions are configured to wrap around a current carrying conductor to form a loop around said current carrying conductor;
- a power supply arrangement configured to feed said data processing arrangement by harvesting electric energy from a magnetic field generated by a current flowing along said current carrying conductor. The power supply arrangement includes a magnetic core formed by said belt of magnetic material and a secondary winding conductor accommodated in the internal volume of said first operational unit. The secondary winding conductor is wound around the intermediate portion of said belt of magnetic material and electrically connected to said data processing arrangement;
- a second operational unit distinct from said first operational unit and configured to couple mechanically, in removable manner, the first and second end portions of said belt of magnetic material one to another to secure said electronic device to said current carrying conductor.

The second operational unit is configured so that, when they are mechanically coupled, the first and second end portions of said belt of magnetic material mutually overlap, at least partially, without touching each other. In this way, the belt of magnetic material forms a looped magnetic circuit enchained with said current carrying conductor and having an airgap, which is formed by the separation space between the first and second end portions of said belt of magnetic material.

According to an aspect of the invention, the second operational unit has a second insulating housing defining an internal volume of said second operational unit. The internal volume of said second operational unit has first and second sections configured to receive, respectively, the first and second end portions of said belt of magnetic material.

Preferably, the first and second sections of internal volume of said second operational unit are separated one to another by a partitioning wall.

The first section of internal volume of said second operational unit accommodates first clamping means configured to fix the first end portion of said belt of magnetic material to the second insulating housing of said second operational unit.

The second section of internal volume of said second operational unit accommodates second clamping means configured to fix the second end portion of said belt of magnetic material to the second insulating housing of said second operational unit.

According to an aspect of the invention, the above-mentioned first clamping means include a stop element fixed to the second insulating housing of said second operational unit. Said stop element has one or more first guiding surfaces defining, in cooperation with one or more second guiding surfaces of said second insulating housing, a first passageway for the first free end portion of said belt of magnetic material. Said stop element is configured to exert a clamping force on the first end portion of said belt of magnetic material, when this latter is inserted in said first passageway.

According to an aspect of the invention, the above-mentioned first clamping means include a clamping lever hinged to the second insulating housing of said second operational unit. Said clamping lever includes one or more third guiding surfaces defining, in cooperation with one more fourth guiding surfaces of said second insulating housing, a second passageway for the second end portion of said belt of magnetic material in parallel to the first passageway for the first end portion of said belt of magnetic material.

Said clamping lever is rotatably movable, in a reversible manner, between an open position and a closed position.

When it is in said open position, said clamping lever allows said second end portion to be inserted in or removed from said second passageway.

When it is in said closed position, said clamping lever exerts a clamping force on the second end portion pf said belt of magnetic material, when said second end portion is inserted in said second passageway.

According to an aspect of the invention, said clamping lever includes one or more fifth guiding surfaces defining, in cooperation with one more sixth guiding surfaces of said second insulating housing, a third passageway for the second end portion of said belt of magnetic material in parallel to said second passageway.

Said third passageway is configured to receive a stretch of said second end portion coming out from said second passageway, when said second end portion is inserted in said second passageway.

According to an aspect of the invention, the second insulating housing of said second operational unit has seventh guiding surfaces defining one or more fourth passageways for the second end portion of said belt of magnetic material in parallel to said first and second passageways and in corresponding one or more intermediate positions between said first and second passageways. The second end portion of said magnetic belt being inserted in one of said fourth passageways before being inserted in said second passageway.

Preferably, the second insulating housing of said second operational unit has seventh guiding surfaces defining a plurality of fourth passageways between said first and second passageways, at increasing distances from said first passageway.

According to an aspect of the invention, the data processing arrangement accommodated in said first operational unit comprises a power supply module electrically connected to said secondary winding conductor in such a way to receive an electric signal forming a power supply from said secondary winding conductor. Said power supply module is configured to process said electric signal to provide one or more power supply voltages to one or more components of said data processing arrangement.

According to an aspect of the invention, said data processing arrangement comprises a sensor interface module operatively coupled or couplable to said one or more sensors to receive said detection signals.

According to an aspect of the invention, said data processing arrangement comprises a control module operatively coupled to said sensor interface module to receive detection data from said sensor interface module and process said detection data.

According to an aspect of the invention, said data processing arrangement comprises a communication module operatively coupled to said data processing module and including a wireless transceiver to communicate with a computerized device in a wireless manner.

According to an aspect of the invention, said data processing arrangement comprises a data interface module operatively coupled to said data processing module and including a data port to exchange data with a computerized device.

In a further aspect, the present invention relates to a low-voltage electric electrical installation, according to the following claim 16.

For a better understanding of the present invention, reference is made to the accompanying drawings and to the detailed description hereinafter, in which preferred but non-limitative embodiments of the differential pressure transmitter according to the present invention are illustrated. In the drawings:
- Figures 1-8 schematically show an embodiment of the electronic device, according to the invention;
- Figure 9 schematically shows another embodiment of the electronic device, according to the invention;
- Figures 10-11 schematically show the general mounting or removal operations of the electronic device, according to the invention.

With reference to the aforesaid figures, the present invention relates to an electronic device 1 particularly adapted for use in low-voltage electrical installations, e.g., electric grids, electric switchgear systems, electric switchboards, and the like.

For the purposes of the present invention, the term "low voltage" (LV) relates to operating voltages generally lower than 2 kV AC and 2.5 kV DC.

The electronic device 1 is configured to interface with or include one or more sensors 5 of an electrical installation.

In principle, the sensors 5 may be configured to detect any physical quantities of interest, for example current, voltage, electric field, temperature, humidity, vibration, noise, and the like. Preferably, the above-mentioned one or more sensors include a temperature sensor 5 configured to detect the temperature of a current carrying conductor 10 of an electrical installation.

As it will better emerge from the following, said one or more sensors may be structurally integrated, at least partially, with an operational unit of the electronic device (as shown in the cited figures) or form separate entities from the electronic device.

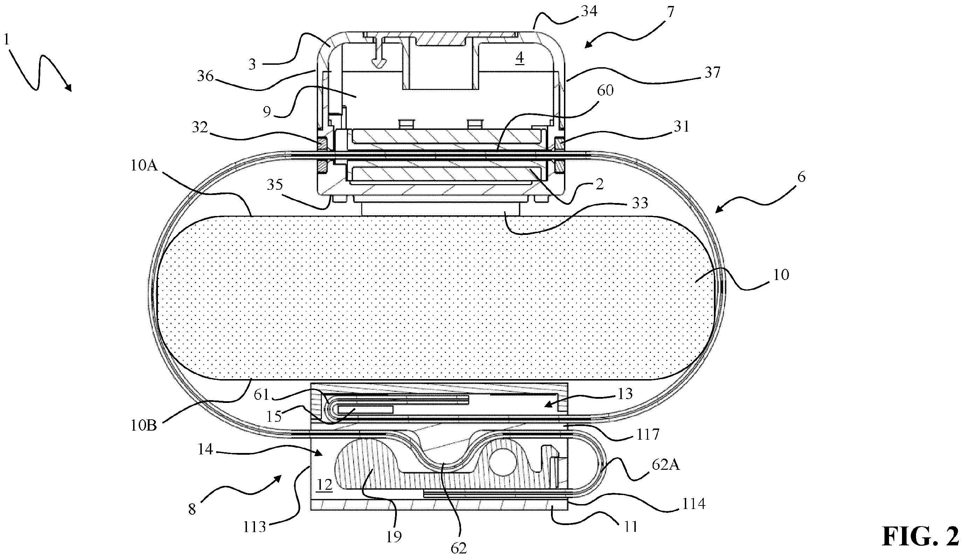

The electronic device 1 is also configured to be installed on a current carrying conductor 10 and harvest electric power from the magnetic field generated by a current flowing along said current carrying conductor. The current carrying conductor 10 may be any live conductor of a low-voltage electrical installation, for example a bus bar, as shown in figure 2.

According to the invention, the electronic device 1 comprises a first operational unit 7 having a first insulating housing 3 defining an internal volume 4.

The insulating housing 3 is made of electrically insulating material and it is preferably shaped as a contoured box with opposite top and bottom walls 34, 35, first and second opposite lateral walls 36, 37 and third and fourth opposite lateral walls 38, 39.

For the sake of clarity, it is specified that relative terms used in this disclosure, e.g., "front", "rear", "lateral", "upper", "lower", "top" and "bottom" and the like relate to an operational unit of the electronic device of the invention in its normal mounting conditions on a current carrying conductor, as shown in figure 2.

When the electronic device is installed, the first operational unit 7 is preferably located at a first surface 10A of the current carrying conductor 10.

Preferably, the insulating housing 3 has its top and bottom walls 34, 35 respectively in distal and proximal position relative to the first surface 10A of the current carrying conductor 10, when the electronic device is installed on this latter.

Preferably, the insulating housing 3 is made up of a main shell and a cover joined to each other through suitable fitting means of known type, such as snap fit connectors (as shown in the cited figures) or screws.

The main shell of the insulating housing 11 forms the bottom wall 35 and suitable portions of the lateral walls 36-39 while the cover forms the top wall 34 and other suitable portions of said lateral walls.

The cited figures show embodiments of the invention, in which a temperature sensor 5 is structurally integrated with the first operational unit 7.

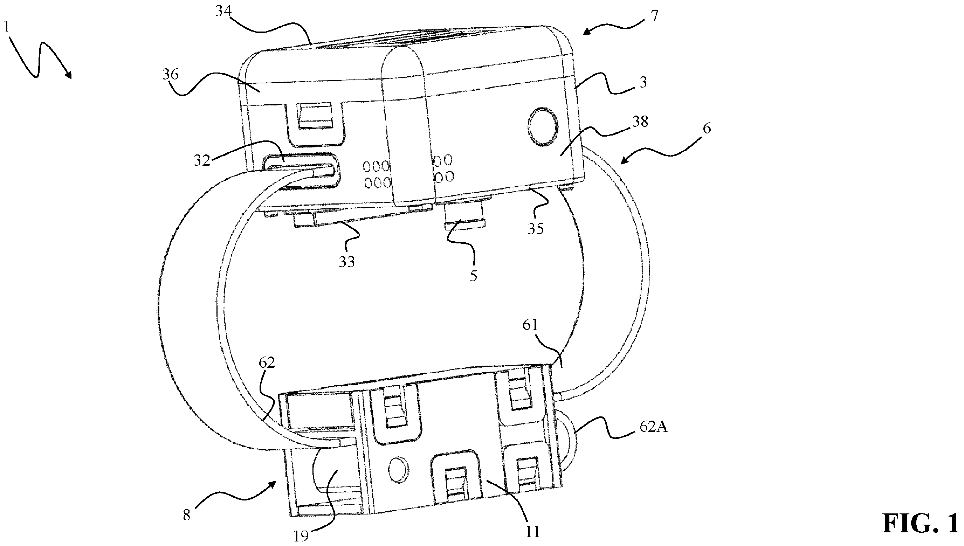

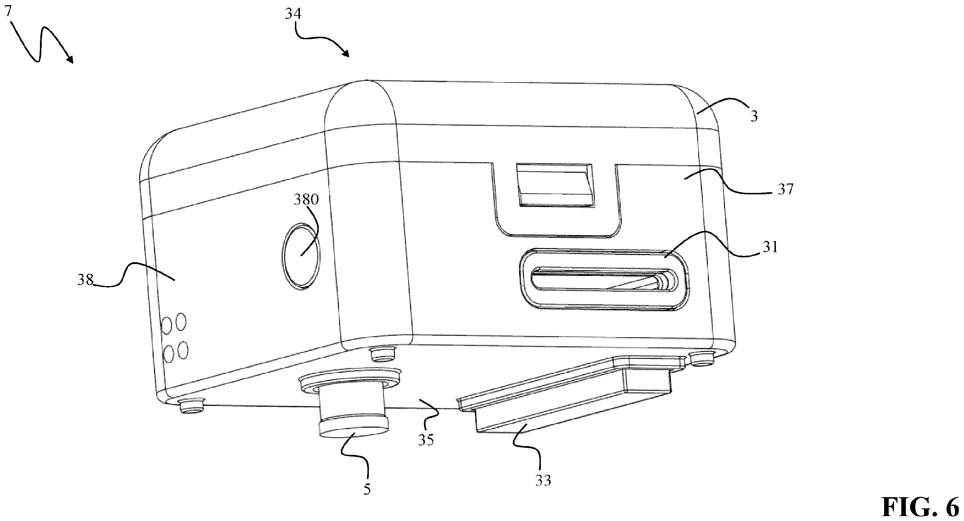

In this case, the temperature sensor 5 is fixed to the first housing 3 and it protrudes outwardly from this latter at the bottom wall 35 (figures 1, 5-6). The temperature sensor 5 can thus be located in proximity of or, preferably, in contact with the surface of the current carrying conductor 10, when the electronic device is installed on this latter.

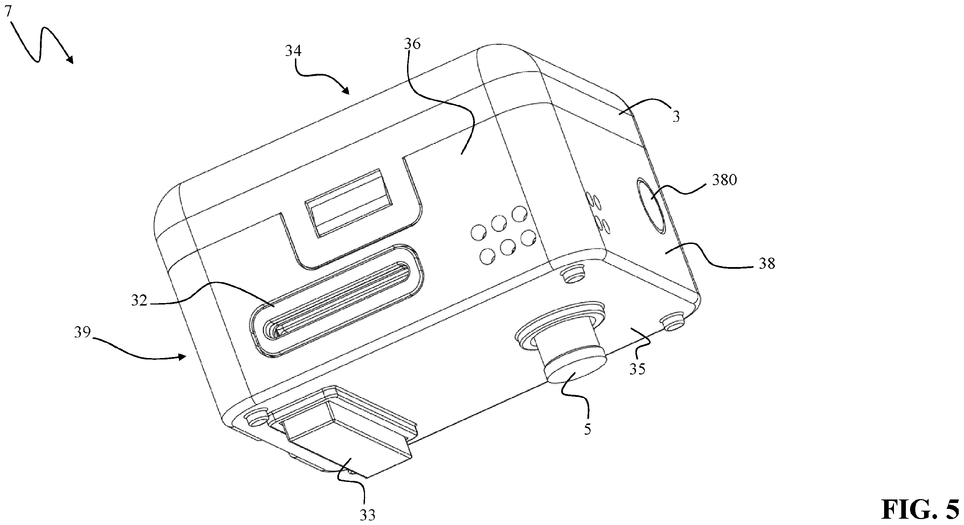

According to some embodiments of the invention (figure 5), the first operational unit 7 comprises a pad 33 made of soft material (e.g., rubber), which protrudes outwardly from the bottom wall 35. The soft pad 33 is configured to be in contact with the surface of the current carrying conductor 10, when the electronic device is installed on this latter. In this way, it stabilizes the positioning of the first operational unit 7 on the current carrying conductor. According to the invention, the electronic device 1 further comprises a data processing arrangement 9 accommodated in the internal volume 4 of the first operational unit 7 and configured to receive and process detection signals S indicative of one or more physical quantities from the one or more sensors 5 operatively coupled to or included in the electronic device.

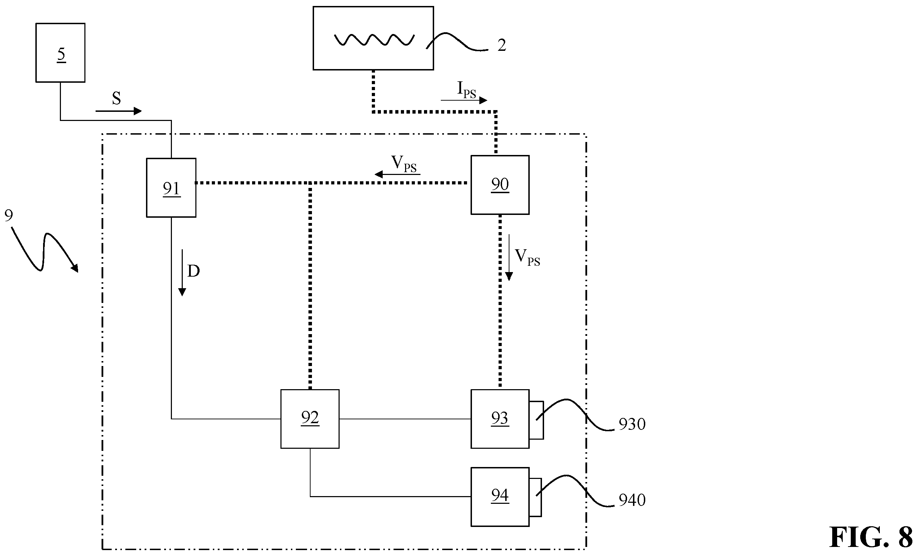

The data processing arrangement 9 comprises a number of electronic modules operatively coupled one to another (figure 8). Said electronic modules are preferably arranged on a printed circuit board fixed to the first insulating housing 3 accommodated in the first operation unit 7, conveniently in a portion of the internal volume 4 in proximity of the top wall 34 of the first insulating housing 3.

According to an aspect of the invention, the data processing arrangement 9 comprises a sensor interface module 91 operatively coupled or couplable to the one or more sensors to receive the detection signals S.

The sensor interface module 91 may receive the detection signals S from the one or more sensors over wire connections, optical fibre connections, or a short-range wireless link. According to the embodiments of the invention shown in the cited figures, the temperature sensor 5 is operatively coupled to the sensor interface module 91 through suitable wire connections. In this case, the temperature sensor 5 may be arranged on the same printed circuit board of the data processing arrangement 9 and the related wire connections can be formed by suitable conductive tracks arranged on said circuit board.

The sensor interface module 91 may conveniently comprise suitable sampling circuits and other data processing circuits to process the received detection signals S. In this way, the sensor interface module 91 can provide in output detection data D indicative of the detected physical quantities.

According to an aspect of the invention, the data processing arrangement 9 comprises a control module 92 operatively coupled to the sensor interface module 91 (e.g., through suitable conductive tracks of a printed circuit board).

The control module 92 is configured to receive the detection data D from the sensor interface module 91 and process said detection data, according to the needs.

The data processing module 92 may conveniently comprise suitable data processing circuits configured to process the received detection data D and other control circuits to interact with the electronic modules operatively coupled thereto. In this way, the control module 92 can provide in output the received detection data D, other information obtained by processing said detection data and suitable data or control signals to interact with other electronic modules. According to an aspect of the invention, the data processing arrangement 9 comprises a communication module 93 operatively coupled to the control module 92 (e.g., through suitable conductive tracks of a printed circuit board).

The communication module includes a wireless transceiver 930 configured to communicate with a computerized device (not shown) in a wireless manner.

The wireless transceiver 930 may be of any type and it may communicate with the above-mentioned computerized device through a local WAN or at remote level through the Internet or phone communication networks.

The communication module 93 is configured to transmit the detection data D provided by the sensor interface module 91 and/or other suitable information obtained by processing said detection data to the computerized device operatively coupled thereto.

In the embodiments shown in the cited figures the wireless transceiver 930 is located at the lateral wall 38 of the insulating housing 3. Other arrangements are however possible, according to the needs.

Preferably, the lateral wall 38 of the insulating housing comprises a portion 380 of semitransparent material, through which a user can see light signals emitted by a suitable signaling device (e.g., a LED device - not shown) of the communication module 93. In this way, a user can check whether the communication module 93 is operating.

According to an aspect of the invention, the data processing arrangement 9 comprises a data interface module 94 operatively coupled to the control module 92 (e.g. through suitable conductive tracks of a printed circuit board).

The data interface module 94 includes a data port 940 (e.g. a USB port) configured to communicate with a computerized device (not shown) at local level. The computerized device may be wired to the data port 940 or wirelessly coupled to the data interface module 94 through a dongle (not shown) inserted in the data port 940.

In the embodiments shown in the cited figures, the data port 940 is located at the top wall 34 of the insulating housing 3. Other arrangements are however possible, according to the needs. The data interface module 94 is configured to make available the detection data D provided by the sensor interface module 91 and/or other suitable information obtained by processing said detection data to the computerized device operatively coupled thereto.

According to the invention, the electronic device 1 further comprises a flexible belt 6 of magnetic material.

Preferably, the belt 6 is made of ferromagnetic material, e.g. ferrite, a Fe-Si alloy or, more, generally, any soft-magnetic material.

According to some embodiments of the invention, the magnetic material of the belt 6 is also a thermo-shrinking material, e.g., polyvinylidene fluoride.

The belt 6 is mechanically connected (possibly in a sliding manner) to the insulating housing 3 of the first operational unit 7.

The belt 6 comprises an intermediate portion 60 passing through the internal volume 4 of the first operational unit 7 and protruding from opposite sides of the insulating housing 3 in such a way to be mechanically coupled to this latter.

Preferably, within the first operational unit 7, the intermediate portion 60 of the belt 6 crosses a portion of the internal volume 4 located in proximity of the bottom wall 35 of the first insulating housing 3.

Preferably, the intermediate portion 60 of the belt 6 passes through two windows 31, 32 of the first insulating housing 3, which are arranged at opposite sides of this latter, for example at the first and second lateral walls 36, 37 of the first insulating housing 3.

The belt 6 further comprises opposite first and second end portions 61, 62 that include each a free end of the belt 6.

The first and second end portions 61, 62 of the belt 6 are configured to wrap around the current carrying conductor 10 to form a loop around it.

Preferably, the intermediate portion 60 of the belt 6 can slide from one side to the other relative to the first insulating housing 3.

When the electronic device is installed on the current carrying conductor 10, the first and second end portions 61, 62 of the belt 6 can thus change their relative position with respect to the first insulating housing 3 and the current carrying conductor by slidingly moving the intermediate portion 60 of the belt 6 relative to first insulating housing 3.

According to the invention, the electronic device 1 comprises a power supply arrangement 2, 6 that is configured to feed the data processing arrangement 9 by harvesting electric energy from a magnetic field generated by a current flowing along the current carrying conductor 10. Such a power supply arrangement includes a magnetic core formed by the belt 6 of magnetic material, which forms a magnetic circuit configured to surround the current carrying conductor 10 (which thus forms a primary winding conductor) in such a way be enchained with this latter. The power supply arrangement further includes a secondary winding conductor 2 accommodated in the internal volume 4 of the first operational unit 7.

The secondary winding conductor 2 is wound around the intermediate portion 60 of the belt 6 of magnetic material (more particularly a stretch of intermediate portion included in the internal volume of the first operational unit) and it is electrically connected to the data processing arrangement 9 in such a way to provide a power supply (preferably a feeding current Irs) to said data processing arrangement. In this way, the data processing arrangement 9 does not need for batteries to operate.

As it is possible to notice, the power supply arrangement 2, 6 is basically configured as an amperometric transformer.

When a current flows along the current carrying conductor 10, an electric signal (namely a feeding current Irs) is generated at the terminals of the secondary winding conductor 2. Such an electric signal forms a power supply suitable for feeding the data processing arrangement.

According to an aspect of the invention, the data processing arrangement 9 comprises a power supply module 90 electrically connected to the secondary winding conductor 2 in such a way to receive an electric signal Irs (e.g., a feeding current) forming a power supply from said secondary winding conductor.

The power supply module 90 is configured to process the electric signal Irs to provide one or more power supply voltages Vrs to feed one or more components of the data processing arrangement 9, for example the above-mentioned electronic modules 91-94.

According to some embodiments of the invention (not shown), the power supply module 90 includes a switch operable by a user to switch on or switch off the electronic device (namely the data processing arrangement 9). The above-mentioned switch may be formed by a button that protrudes from the first insulating housing 3 in such a way that a user can press it.

An essential aspect of the present invention consists in that the electronic device 1 comprises a second operational unit 8 configured to couple mechanically, in removable manner, the first and second end portions 61, 62 of the belt 6 of magnetic material one to another in such a way to secure said electronic device (more particularly the first operational unit 7) to the current carrying conductor 10.

The second operational unit 8 is configured so that the first and second end portions 61, 62 of the belt 6 mutually overlap, at least partially, without touching each other, when they are mechanically coupled one to another. In this way, the belt 6 of magnetic material forms a looped magnetic circuit enchained with the current carrying conductor 10.

The looped magnetic circuit has however an airgap formed by the separation space between the first and second end portions 61, 62 of the belt 6 of magnetic material.

According to an aspect of the invention, the second operational unit 8 has a second insulating housing 11 defining an internal volume 12 of said second operational unit.

The insulating housing 11 is made of electrically insulating material and it is preferably shaped as a contoured box with opposite top and bottom walls 111, 112, fifth and sixth opposite lateral walls 113, 114 and seventh and eighth opposite lateral walls 115, 116.

When the electronic device is installed, the second operational unit 8 is preferably located at a second surface 10B of the current carrying conductor 10. The second surface 10B is preferably in an opposite position relative to the above-mentioned first surface 10A where the first operational unit 7 is located.

Preferably, the top and bottom walls 34, 35 are respectively in a proximal and distal position relative to the second surface 10B of the current carrying conductor 10 when the electronic device is installed on this latter.

Preferably, the insulating housing 11 is made up of a main body 110 joined to a top cover 111A and a bottom cover 112A through suitable fitting means of known type, such as snap fit connectors (as shown in the cited figures) or screws.

The above-mentioned main body forms suitable portions of the lateral wall 113-116 while the above-mentioned top and bottom covers 111A, 112A form respectively the top and bottom walls 111, 112 of the insulating housing 11 and other suitable portions of the lateral walls 113-116.

The second operational unit 8 has first and second sections 13, 14 of internal volume, which are configured to receive, respectively, the first and second end portions 61, 62 of the belt 6 of magnetic material.

Preferably, the first and second sections 13, 14 of internal volume are separated one from another.

Preferably, the insulating housing 12 comprises a partitioning wall 117 arranged in parallel to the top and bottom walls 11, 12 and separating the first and second sections 13, 14 of internal volume one from another.

According to an aspect of the invention, the first section 13 of internal volume includes a first passageway 18 for the first end portion 61 of the belt 6 of magnetic material and first clamping means 15 configured to fix said first end portion 61 to the insulating housing 11.

According to an aspect of the invention, the second section 14 of internal volume includes a second passageway 22 for the second end portion 62 of the belt 6 of magnetic material and second clamping means 19 configured to fix said second end portion 62 to the insulating housing 11.

According to an aspect of the invention, the above-mentioned first clamping means include a stop element 15 fixed to the insulating housing 11 and arranged in the first section 13 of internal volume.

The stop element 15 may be conveniently formed by a transversal pin fixed to the insulating housing 11 and arranged perpendicularly to the lateral walls 115, 116. As an alternative, the stop element 15 may be formed by a transversal beam of the insulating housing 11 arranged perpendicularly to the lateral walls 115, 116

Preferably, the stop element 15 has one or more first guiding surfaces 16 that define, in cooperation with one or more second guiding surfaces 17 of the insulating housing 11 (namely of the top wall 111 and of the internal partitioning wall 117), the first passageway 18. Preferably, the first passageway 18 extends through the first section 13 of internal volume perpendicularly to the fifth and sixth lateral walls 113, 114 of the insulating housing 11, more preferably in proximity of the top wall 114.

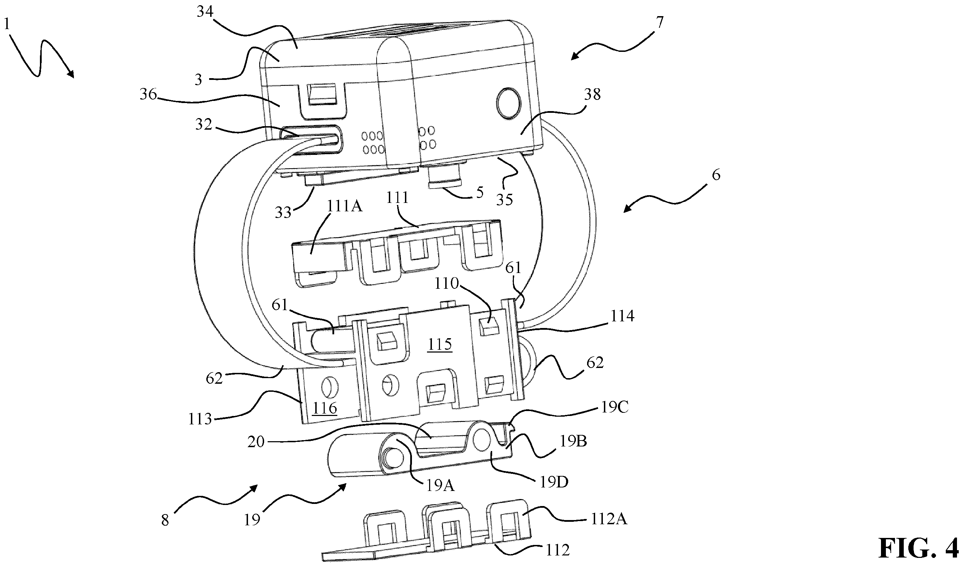

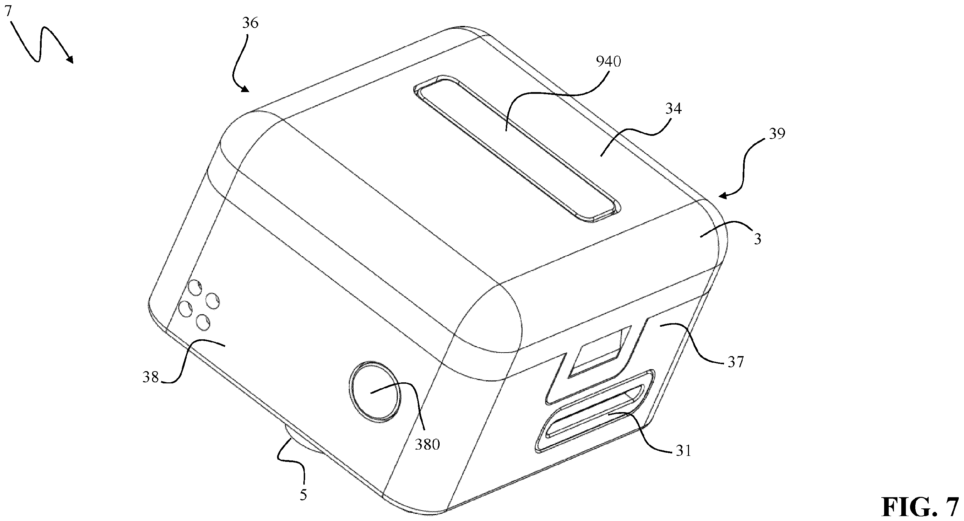

Preferably, the first passageway 18 is open to the outer environment and it has a blind bottom. In the embodiments shown in figures 1-8, the first passageway 18 is open to the outer environment at the sixth lateral wall 114 while it has the blind bottom in proximity of the opposite fifth lateral wall 113.

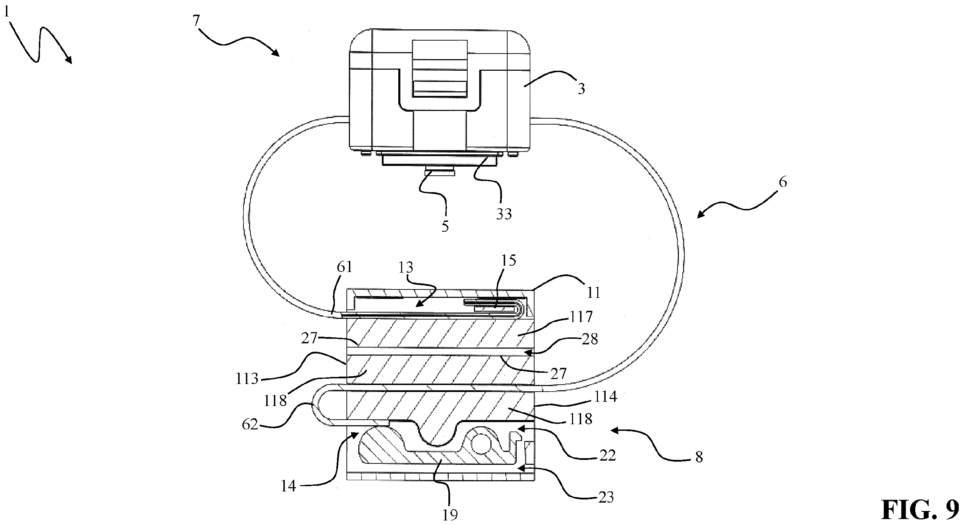

In the embodiment shown in figure 9, instead, the first passageway 18 is arranged in an opposite way, in the sense that it is open to the outer environment at the fifth lateral wall 113 while it has the blind bottom in proximity of the opposite sixth lateral wall 114.

In both cases, the stop element 15 is conveniently located at the blind bottom of the first passageway 18.

According to the embodiments shown in figures 1-8, while installing the electronic device, the first free end portion 61 of the belt 6 is inserted in the first passageway 18 at the sixth lateral wall 114 of the insulating housing 11 and it is folded around the stop element 15 in proximity of the fifth lateral wall 113.

According to the embodiment shown in figure 9, while installing the electronic device, the first free end portion 61 of the belt 6 is inserted in the first passageway 18 at the fifth lateral wall 113 of the insulating housing 11 and it is folded around the stop element 15 in proximity of the sixth lateral wall 114.

In both cases, the stop element 15 exerts a clamping force on the first end portion 61 of the belt 6 inserted in the first passageway 18 and it fixes it to the insulating housing 11.

According to an aspect of the invention, the above-mentioned second clamping means include a clamping lever 19 hinged to the insulating housing 11 and arranged at the second section 14 of internal volume.

Preferably, the clamping lever 19 includes one or more third guiding surfaces 20 defining, in cooperation with one more fourth guiding surfaces 21 of the insulating housing 11, the second passageway 22.

Preferably, the third guiding surfaces 20 of the clamping lever 19 and the fourth guiding surfaces 21 of the insulating housing 11 are oriented respectively towards the top wall 111 and the bottom wall 112 of the insulating housing 11.

Preferably, the fourth guiding surfaces 21 of the insulating housing 11 are formed by suitable shaped surfaces of the partitioning wall 117 (figure 2) or another internal wall 118 of the second section 14 of internal volume (figure 9).

Preferably, the second passageway 22 extends through the second section 14 of internal volume perpendicularly to the fifth and sixth lateral walls 113, 114 of the insulating housing 11. The second passageway 22 extends through the second section 14 of internal volume in parallel to the first passageway 18.

Preferably, the first passageway 18 is open to the outer environment at opposite sides.

In the embodiments shown in the cited figures, the second passageway 22 is open to the outer environment at both the lateral walls 114, 115 of the insulating housing.

While installing the electronic device, the second end portion 62 of the belt 6 is inserted in the second passageway 22 at the fifth lateral wall 113 of the insulating housing 11. Depending on its length, when the second end portion 62 is inserted in the second passageway 22, a stretch 62A of said second end portion may come out from the second passageway 22. As it will better emerge from the following, the stretch 62A of the second end portion 62 can be folded for being inserted in a further passageway of the insulating housing 11.

The clamping lever 19 can move about a rotation axis perpendicular to the lateral walls 115, 116 of the insulating housing 11.

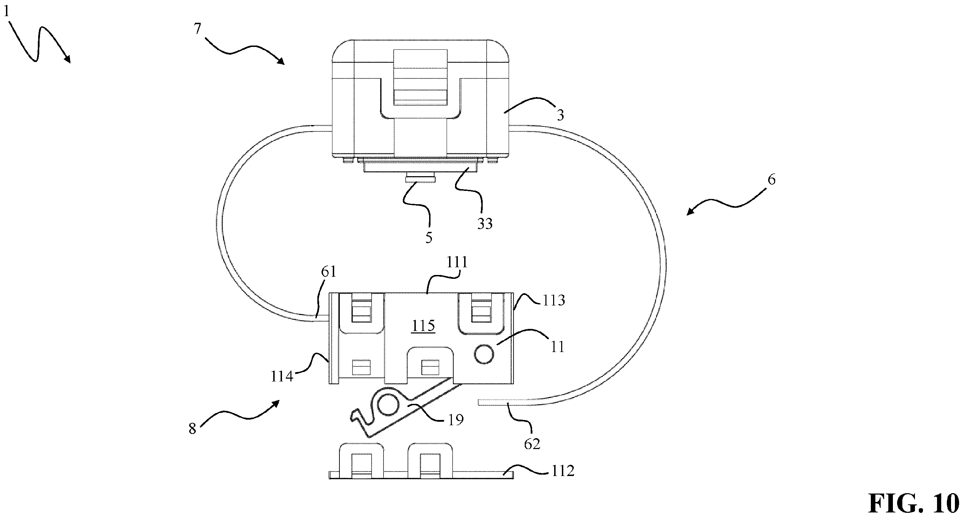

The clamping lever 19 is rotatably movable, in a reversible manner, between an open position P1 (figure 10) and a closed position P2 (figures 2, 3, 9).

The clamping lever 19 can move between the open and closed positions P1, P2 upon an actuation force manually exerted by a user intending to install or remove the electronic device 1 from the current carrying conductor. As it can be easily understood from the cited figures, the bottom cover 112A of the insulating housing 11 must be removed in order to operate the clamping lever 19. When it is the open position P1, the clamping lever 19 allows the second end portion 62 of the belt 6 to be inserted in or removed from the second passageway 22. When it is in the closed position P2, the clamping lever 19 exerts a clamping force on the second end portion 62 of the belt 6, if said second end portion is inserted in the second passageway 22. In this case, the clamping lever 19 is capable to fix the second end portion 62 of the belt 6 to the insulating housing 11.

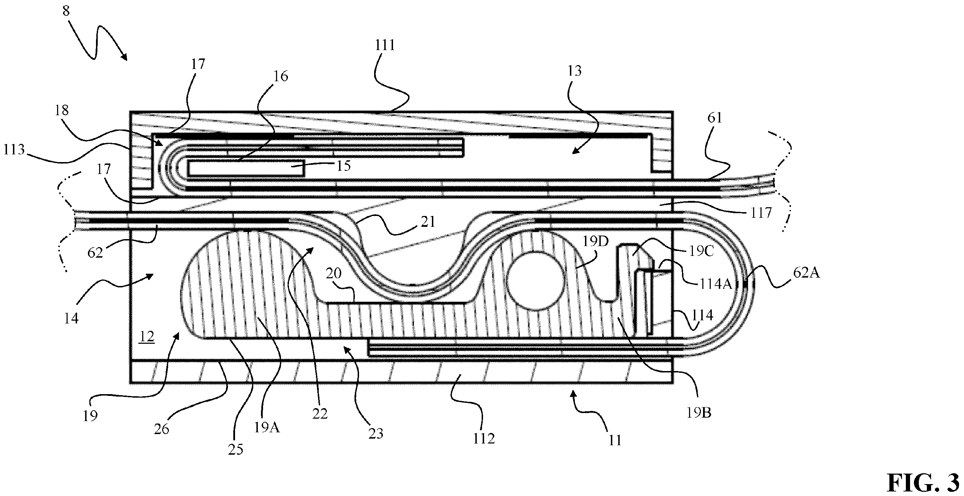

According to the embodiments shown in the cited figures, the clamping lever 19 has an elongated body having hinged to the insulating housing 11 at an end 19A located in proximity of the lateral wall 113 of the insulating housing 11 (figure 3).

The body of the clamping lever 19 has an opposite end 19B located in proximity of the opposite lateral wall 114 of the insulating housing 11.

The end 19B of the clamping lever 19 is conveniently provided with snap-fitting means 19C configured to engage a suitable toothed surface 114A of the lateral wall 114, when the clamping lever 19 is in the closed position P2. In this way, the clamping lever 19 can be secured in the closed position P2, even if it exerts a clamping force the second end portion 62 of the belt 6. Advantageously, the body of the clamping lever 19 has also a holed portion 19D in an intermediate position between the opposite ends 19A, 19B. The holed portion 19D is configured to be grasped by a user's finger or mechanical tool to move the clamping lever 10 from the clamping lever 19, in particular from closed position P2 to the open position P1.

According to an aspect of the invention, the second section 14 of internal volume includes a third passageway 23 for the second end portion 62 of the belt 6 of magnetic material. Preferably, the clamping lever 19 includes one or more fifth guiding surfaces 25 defining, in cooperation with one more sixth guiding surfaces 26 of the second insulating housing, the third passageway 23.

Preferably, the third passageway 23 extends through the second section 14 of internal volume in parallel to the second passageway 22.

Preferably, the second and third passageways 22, 23 for the second end portion 62 are located at opposite sides of the clamping lever 19.

Preferably, the second and third passageways 22, 23 of the second section 14 of internal volume are located respectively in a distal and proximal position relative to the bottom wall 112 of the insulating housing 11.

Preferably, the fifth guiding surfaces 25 of the clamping lever 19 and the sixth guiding surfaces 26 of the insulating housing 11 are oriented respectively towards the bottom wall 112 and the top wall 111 of the insulating housing 11.

Preferably, the fifth guiding surfaces 25 of the clamping lever 19 are opposite to the above-mentioned third guiding surfaces 20 defining the second passageway 22.

Preferably, the sixth guiding surfaces 26 of the insulating housing 11 are formed by suitable shaped surfaces of the bottom wall 12 of the insulating housing 11.

The third passageway 23 is configured to receive a stretch 62A of the second end portion 62 of the belt 6, which comes out from the second passageway 18, when the second end portion 62 is inserted in the second passageway 22.

While installing the electronic device, the second end portion 62 of the belt 6 is inserted in the second passageway 22 and the clamping lever 19 is brought in the closed position P2. The stretch 62A of the second end portion 62, which comes out from the second passageway 22, is folded and it is inserted in the third passageway 23.

The insertion of the second end portion 62 in a third passageway 23 at an opposite side of the clamping lever 19 helps to fix said second end portion to the insulating housing 11.

According to an aspect of the invention, the second section 14 of internal volume includes one or more fourth passageways 28 for the second end portion 62 of the belt 6 of magnetic material. Preferably, the partitioning wall 117 and one or more internal walls 118 of the insulating housing in the second section 14 of internal volume have seventh guiding surfaces 27 defining the one or more fourth passageways 28.

Preferably, the fourth passageways 28 extend through the second section 14 perpendicularly to the fifth and sixth lateral walls 113, 114 of the insulating housing 11.

At both the lateral walls 114, 115, the fourth passageways 28 are open to the outer environment. The one or more fourth passageways 28 extend through the second section 14 of internal volume in parallel to the first and second passageways 18, 22.

The one or more fourth passageways 28 are located at corresponding one or more intermediate positions between the first and second passageways 18, 22.

In the embodiments shown in figure 9, the second section 14 of internal volume comprises a plurality of fourth passageways 22 between the first and second passageways 18, 22, at increasing distances from the first passageway 18.

In other embodiments (not shown), however, the second section 14 of internal volume may comprise a single fourth passageway 28 between the first and second passageways 18, 22. Preferably, the seventh guiding surfaces 27 of the insulating housing 11 are formed by suitable shaped surfaces of the partitioning wall 117 and of one or more internal walls 118 of the housing 11.

While installing the electronic device, the second end portion 62 of the belt 6 is inserted in in one of the fourth passageways 28 before being inserted in the second passageway 22.

After having been inserted in one of the fourth passageways 28, the second end portion 62 is folded and then inserted through the second passageway 22 for being clamped by the clamping lever 19.

The solution provided by the embodiment of figure 9 is particularly advantageous. By inserting the second end portion 62 of the belt 6 in different selectable passageways 28, the user can tune the extension of the airgap of the magnetic circuit formed by the belt 6. This allows tuning the level of attenuation of possible spikes or peaks of the electric signal Irs provided at the output terminals of the secondary winding 2.

### Mounting of the electrical device on a current carrying conductor

The mounting operations of the electrical device on a current carrying conductor are briefly described in the following. The electronic device is supposed to have the first and second operational units 7, 8 and the belt 6 disassembled one from another.

A user can preliminarily fix the first end portion 61 of the belt 6 to the second operational unit 8. To this aim, the user has to remove the top cover 111A of the insulating housing 11, insert the first end portion 61 of the belt 6 in the first passageway 18 and then fix again the top cover 111A to the main body 110 of the insulating housing 11.

A user can also preliminarily remove the bottom cover 112A of the insulating housing 11 and move the clamping lever 19 from the closed position P2 to the open position P1 by grasping it at the holed portion 19D and rotating it away from the main body 110 of the insulating housing 11 (figure 10).

In order to install the electronic device, a user can put the first operational unit 7 on a first surface 10A of the current carrying conductor and wrap the first end portion 61 (with the second operation unit 8 attached thereto) and the second end portion 62 of the belt 6 around the current carrying conductor 10.

The user can then insert the second end portion of the belt 6 in the second passageway 22 of the second operational unit 8.

Possibly, before doing so, the user can insert the second end portion 62 of the belt 6 in a selected fourth passageway 28 of the second operational unit 8 and fold the stretch of second end portion coming out from the fourth passageway 28 (figure 9).

After having inserted the second end portion 62 in the second passageway 22, the user can move the clamping lever 19 in the closed position P2 by rotating it towards the main body of the insulating housing 11. When doing so, the user can exert a pressure on the clamping lever 19 to engage the snap-fitting means 19C with the toothed surface 114A of the insulating housing 11.

Obviously, before closing the clamping lever 19, the user has to pull the second portion 62 in such a way to fit the belt 6 to the current carrying conductor 10. In this way, the second operational unit 8 can be positioned at a second surface 10B of the current carrying conductor 10.

The user can then fix the bottom cover 112A (previously removed) to the main body 110 of the insulating housing 11 of the second operational 8.

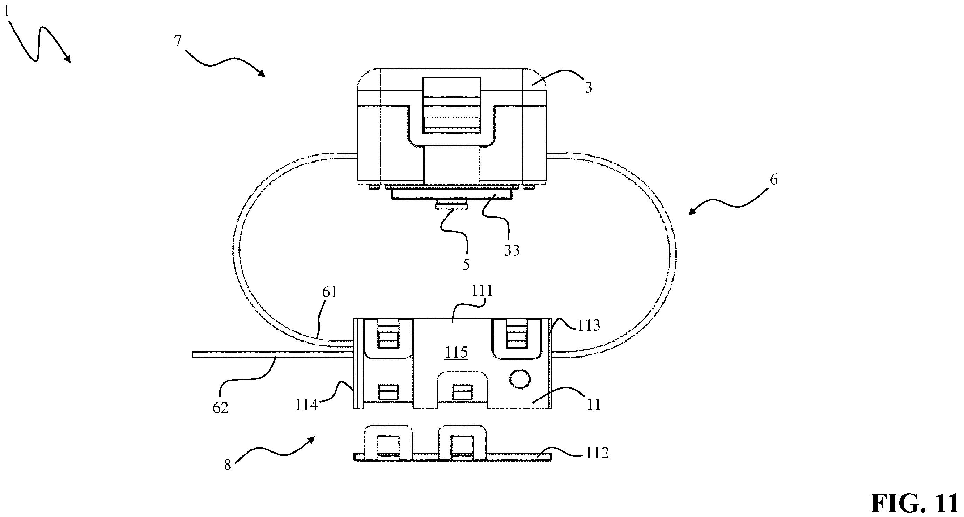

Finally, the user can fold the stretch 62A of the second end portion 62 of the belt 6, which comes out from the second passageway 22, and insert it in the third passageway 23 of the second operational unit 8 (figure 2 and 11).

### Removal of the electrical device from a current carrying conductor

The removal operations of the electrical device from a current carrying conductor are briefly described in the following. The electronic device is supposed to be fixed to a current carrying conductor 10 (figure 2).

The user can initially remove the bottom cover 112A from the insulating housing 11 of the second operational unit 8 (figures 10, 11).

The user can then move the clamping lever 19 from the closed position P2 to the open position P1 by grasping it at the holed portion 19D and rotating it away from the main body 110 of the insulating housing 11. When doing so, the user has to exert a relatively small force on the clamping lever 19 to disengage the snap-fitting means 19C from the toothed surface 114A of the insulating housing 11.

When it is in the open position P1, the clamping lever 19 does not exert any clamping force on the second portion 62 of the belt 6. This latter can then be manually extracted from the second passageway 22 and, possibly, from one of the fourth passageways 28.

Once the extraction of the second portion 62 of the belt 6 from the second operational unit 8 is completed, the belt 6 is released and the electronic device 1 can be completely removed from the current carrying conductor 10.

The electronic device 1, according to the invention, provides remarkable advantages with respect to the known apparatuses of the state of the art.

The electronic device 1 can be easily installed on or removed from a current carrying conductor with simple manual operations and without the use of tools. The electrical device is thus particularly adapted for use (even for retrofitting purposes) in a variety of electrical equipment such as bus bars, panel boards, switchboards, switches or other electrical equipment, even if small spaces are available for intervening on the field.

The electronic device 1 is passively powered and it does not need for batteries or wired supply voltage connections to operate.

By virtue of the airgap between the first and second end portions 61, 62 of the belt 6, when these latter are mechanically coupled by the second operational unit 8 and the electronic device is fixed to the current carrying conductor, it is possible to obtain a power supply signal Irs for the data supply arrangement 9 having possible spikes or peaks naturally attenuated, even in presence of high currents along the current carrying conductor 10. This allows simplifying the electronic circuitry of the data processing arrangement 9 compared to traditional solutions of the state of the art with a consequent decrease of the manufacturing costs.

The electronic device, according to the invention, has a relatively simple and compact structure and it is relatively easy and cheap to manufacture at industrial level.

## Claims

1. An electronic device (1) for low-voltage installations comprising:
- a first operational unit (7) having a first insulating housing (3) defining an internal volume (4) of said first operational unit;
- a data processing arrangement (9) accommodated in the internal volume (4) of said first operational unit and configured to receive and process detection signals (S) indicative of one or more physical quantities and provided by one or more sensors (5) operatively coupled to or included in said electronic device;
- a flexible belt (6) of magnetic material having an intermediate portion (60) and opposite first and second end portions (61, 62), said intermediate portion passing through the internal volume (4) of said first operational unit and being mechanically coupled to said first insulating housing (3), said first and second end portions (61, 62) being configured to wrap around a current carrying conductor (10) to form a loop around said current carrying conductor;
- a power supply arrangement (2, 6) configured to feed said data processing arrangement (9) by harvesting electric energy from a magnetic field generated by a current flowing along said current carrying conductor (10), said power supply arrangement including a magnetic core formed by said belt (6) of magnetic material and a secondary winding conductor (2) accommodated in the internal volume (4) of said first operational unit (7), said secondary winding conductor being wound around the intermediate portion (60) of said belt of magnetic material and electrically connected to said data processing arrangement;
**characterised in that** said it comprises a second operational unit (8) distinct from said first operational unit (7) and configured to couple mechanically, in removable manner, the first and second end portions (61, 62) of said belt (6) of magnetic material one to another to secure said electronic device to said current carrying conductor (10).

2. Electronic device, according to claim 1, **characterized in that**, when said first and second end portions (61, 62) are mechanically coupled, said first and second end portions (61, 62) mutually overlap, at least partially, without touching each other, so that said belt (6) of magnetic material forms a looped magnetic circuit with an airgap enchained with said current carrying conductor (10).

3. Electronic device, according to claim 2, **characterized in that** said second operational unit (8) has a second insulating housing (11) defining an internal volume (12) of said second operational unit having first and second sections (13, 14) configured to receive, respectively, the first and second end portions (61, 62) of said belt (6) of magnetic material,
wherein said first section (13) of internal volume accommodates first clamping means (15) configured to fix the first end portion (61) of said belt (6) of magnetic material to said second insulating housing (11),
wherein said second section (14) of internal volume accommodates second clamping means (19) configured to fix the second end portion (62) of said belt (6) of magnetic material to said second insulating housing (11).

4. Electronic device, according to claim 3, **characterised in that** said first clamping means include a stop element (15) fixed to said second insulating housing (11), said stop element having one or more first guiding surfaces (16) defining, in cooperation with one or more second guiding surfaces (17) of said second insulating housing, a first passageway (18) for the first free end portion (63) of said belt (6) of magnetic material, said stop element exerting a clamping force on said first end portion (63) inserted in said first passageway (18).

5. Electronic device, according to one of the claims from 3 to 4, **characterised in that** said second clamping means includes a clamping lever (19) hinged to said second insulating housing (11) and including one or more third guiding surfaces (20) defining, in cooperation with one more fourth guiding surfaces (21) of said second insulating housing, a second passageway (22) for the second end portion (62) of said belt (6) of magnetic material in parallel to said first passageway (18),
wherein said clamping lever (19) is rotatably movable, in a reversible manner, between an open position (P1) and a closed position (P2),
wherein said clamping lever (19) in said open position (P1) allows said second end portion (62) to be inserted in or removed from said second passageway (22),
wherein said clamping lever (19) in said closed position (P2) exerts a clamping force on said second end portion (62), when said second end portion is inserted in said second passageway (22).

6. Electronic device, according to claim 5, **characterised in that** said clamping lever (19) includes one or more fifth guiding surfaces (25) opposite to said third guiding surfaces (20) and defining, in cooperation with one more sixth guiding surfaces (26) of said second insulating housing, a third passageway (23) for the second end portion (62) of said belt (6) of magnetic material in parallel to said second passageway (22), said third passageway being configured to receive a stretch (62A) of said second end portion (62) coming out from said second passageway (18), when said second end portion (62) is inserted in said second passageway (22).

7. Electronic device, according to one of the claims from 3 to 6, **characterised in that** said second insulating housing (11) has seventh guiding surfaces (27) defining one or more fourth passageways (28) for the second end portion (62) of said belt (6) of magnetic material in parallel to said first and second passageways (18, 22) and in corresponding one or more intermediate positions between said first and second passageways (18, 22), said second end portion (62) being inserted in one of said fourth passageways (28) before being inserted in said second passageway (22).

8. Electronic device, according to claim 7, **characterised in that** said seventh guiding surfaces (27) define a plurality of fourth passageways (22) between said first and second passageways (18, 22), at increasing distances from said first passageway (18).

9. Electronic device, according to one of the previous claims, **characterised in that** said data processing arrangement (9) comprises a power supply module (90) electrically connected to said secondary winding conductor (2) in such a way to receive an electric signal (Irs) forming a power supply from said secondary winding conductor, said power supply module being configured to process said electric signal (Irs) to provide one or more power supply voltages (V_{PS}) to one or more components of said data processing arrangement.

10. Electronic device, according to one of the previous claims, **characterised in that** said data processing arrangement (9) comprises a sensor interface module (91) operatively coupled or couplable to said one or more sensors (5) to receive said detection signals (S).

11. Electronic device, according to claim 10, **characterised in that** said data processing arrangement (9) comprises a control module (92) operatively coupled to said sensor interface module (91) to receive detection data (D) from said sensor interface module and process said detection data.

12. Electronic device, according to claim 11, **characterised in that** said data processing arrangement (9) comprises a communication module (93) operatively coupled to said data processing module (92) and including a wireless transceiver (930) to communicate with a computerized device in a wireless manner.

13. Electronic device, according to claim 11 or 12, **characterised in that** said data processing arrangement (9) comprises a data interface module (94) operatively coupled to said data processing module (92) and including a data port (940) to exchange data with a computerized device.

14. Electronic device, according to one of the previous claims, **characterised in that** said belt (6) of magnetic material is made of a ferromagnetic material.

15. Electronic device, according to one of the previous claims, **characterised in that** said belt (6) of magnetic material is made of a thermo-shrinking material.

16. A low-voltage electrical installation, **characterized in that** it comprises one or more electronic devices (1), according to one of the previous claims, each electronic device being operatively coupled to a corresponding current carrying conductor (10) of said low-voltage electrical installation.
